# EUROPEAN PATENT APPLICATION

(11) **EP 2 400 577 A1**
(43) Date of publication of application: **28.12.2011**
(21) Application number: 11182607.9
(22) Date of filing: 02.02.2007
(51) Int. Cl.: H01L 51/52, H01L 51/54, H01L 51/50

(54) **Phosphorescent organic light emissive device**

(30) Priority: 03.02.2006 GB 0602211
(62) Divisional of application: 07705116.7
(71) Applicant: CDT Oxford Limited, Cambridgeshire CB3 6DW (GB)
(72) Inventor: Conway, Natasha, Cambridge, Cambridgeshire CB3 6DW (GB); Grizzi, Ilaria, Cambridge, Cambridgeshire CB3 6DW (GB)
(74) Representative: Hill, Justin John

(57) **Abstract**

An organic light emissive device comprising: an anode (12); a cathode (20,22); and an organic light emissive layer (18) between the anode (12) and the cathode (20,22), wherein the cathode (20,22) comprises an electron-injecting layer (20) comprising a barium compound or a metal oxide; the organic light emissive layer (18) comprises an organic phosphorescent material; and the electron injecting layer (20) is in direct contact with the organic light emissive layer (18).

## Description

### Field of the Invention

The present invention relates to phosphorescent organic light emissive devices, to full colour displays and the use of cathodes therein.

### Background of the Invention

Organic light emissive devices (OLEDs) generally comprise a cathode, an anode and an organic light emissive region between the cathode and the anode. Light emissive organic materials may comprise small molecular materials such as described in US4539507 or polymeric materials such as those described in PCT/WO90/13148. The cathode injects electrons into the light emissive region and the anode injects holes. The electrons and holes combine to generate photons.

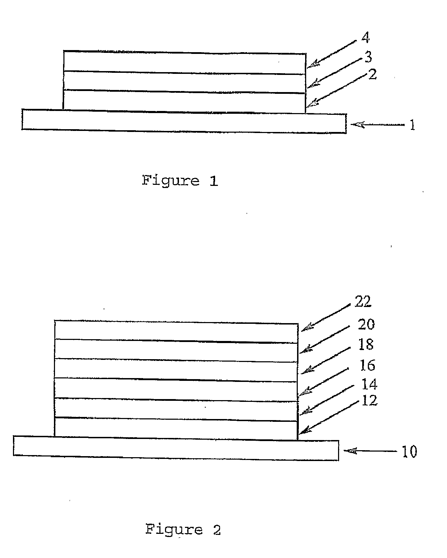

Figure 1 shows a typical cross-sectional structure of an OLED. The OLED is typically fabricated on a glass or plastics substrate 1 coated with a transparent anode 2 such as an indium-tin-oxide (ITO) layer. The ITO coated substrate is covered with at least a layer of a thin film of an electroluminescent organic material 3 and cathode material 4. Other layers may be added to the device, for example to improve charge transport between the electrodes and the electroluminescent material.

There has been a growing interest in the use of OLEDs in display applications because of their potential advantages over conventional displays. OLEDs have relatively low operating voltage and power consumption and can be easily processed to produce large area displays. On a practical level, there is a need to produce OLEDs which are bright and operate efficiently but which are also reliable to produce and stable in use.

The structure of the cathode in OLEDs is one aspect under consideration in this art. In the case of a monochrome OLED, the cathode may be selected for optimal performance with the single electroluminescent organic material. However, a full colour OLED comprises red, green and blue light organic emissive materials. Such a device requires a cathode capable of injecting electrons into all three emissive materials, i.e. a "common electrode".

Cathode 4 is selected from materials that have a workfunction allowing injection of electrons into the electroluminescent layer. Other factors influence the selection of the cathode such as the possibility of adverse interactions between the cathode and the electroluminescent material. The cathode may consist of a single material such as a layer of aluminium. Alternatively, it may comprise a plurality of metals, for example a bilayer of calcium and aluminium as disclosed in WO 98/10621, elemental barium disclosed in WO 98/57381, Appl. Phys. Lett. 2002, 81(4), 634 and WO 02/84759 or a thin layer of dielectric material to assist electron injection, for example lithium fluoride disclosed in WO 00/48258 or barium fluoride, disclosed in Appl. Phys. Lett. 2001, 79(5), 2001. In order to provide efficient injection of electrons into the device, the cathode preferably has a workfunction of less than 3.5 eV, more preferably less than 3.2 eV, most preferably less than 3 eV.

A layer of metal fluoride located between the organic emissive layer (or organic electron transporting layer, if present) and the metal cathode can result in an improvement in device efficiency ― see for example Appl. Phys. Lett. 70, 152, 1997. This improvement is believed to result from a reduction in the barrier height at the polymer / cathode interface, allowing improved electron injection into the organic layer(s). A mechanism of device degradation using the LiF / Al cathode is proposed in Appl. Phys. Lett. 79(5), 563-565, 2001 wherein LiF and Al may react to release Li atoms that can migrate into the electroluminescent layer and dope the electroluminescent material. However, the present inventors have found the LiF / Al cathode to be relatively stable, its main drawback being relatively low efficiency (in particular when used as a common cathode). A more efficient arrangement utilises a tri-layer of LiF/Ca/Al, which is described as a common cathode in Synth. Metals 2000, 111-112, p.125-128. However, it is reported in WO 03/019696 that degradation is particularly marked for devices comprising this cathode and fluorescent electroluminescent materials comprising sulfur such as the red emitting polymer comprising the trimer repeat unit thiophene-benzothiadiazole-thiophene. WO 03/019696 proposes using a barium based material rather than LiF and discloses a tri-layer structure of BaF₂/Ca/Al for these fluorescent electroluminescent materials comprising sulfur. The use of other barium compounds including barium halides and barium oxide is also mentioned as a possibility in WO 03/019696.

US 6,563,262 proposing using a bilayer of a metal oxide (e.g. BaO) with aluminium for fluorescent poly(p-phenylene vinylene) emissive materials (PPVs).

Synthetic Metals 122 (2001) p.203-207 discloses a phosphorescent OLED having the structure ITO / NPB / EL / BCP / Alq₃ / Li₂O / Al wherein "NPB" is a layer of organic hole transporting material, "EL" is an organic electroluminescent layer comprising a host material CBP and phosphorescent dopant material Ir(ppy)₃, "BCP" is a layer of organic hole blocking material and "Alq₃" is a layer of organic electron transporting material. This article describes optimisation of optical distances between layer boundaries by selection of the thickness of the NPB, CBP + Ir(ppy)₃ and Alq₃ layers.

Synthetic Metals 151 (2005) p.147-151 discloses a white light emitting phosphorescent OLED having the structure ITO / PEDOT / EL / BCP / Alq3 / BaF₂ / Al wherein "EL" represents an electroluminescent layer of a host material PVK, a red phosphorescent dopant (btpy)₂Ir(acac) and a blue phosphorescent dopant Firpic. As with Synthetic Metals 122 (2001) p.203-207, an organic hole blocking layer and an organic electron transporting layer is provided between the cathode and the electroluminescent layer.

An aim of the present invention is to provide an organic light emissive device including a cathode and phosphorescent organic electroluminescent material with improved properties.

A further aim is to provide a cathode capable of increasing opto-electrical efficiency for a variety of different types of organic light emissive materials at least one of which comprises an organic phosphorescent material, i.e. a "common electrode", so that emission from red, green and blue sub-pixels in a full colour display is improved using a single cathode.

### Summary of the Invention

According to a first aspect of the present invention there is provided an organic light emissive device comprising: an anode; a cathode; and an organic light emissive layer between the anode and the cathode, wherein the cathode comprises an electron-injecting layer comprising an oxide of an alkaline earth metal and wherein the organic light emissive layer comprises an organic phosphorescent material.

It has surprisingly been found that an electron injecting layer comprising an oxide of an alkaline earth metal gives excellent device performance when utilized with an organic phosphorescent material in comparison to other electron injecting materials such as low work function elements (e.g. barium) or other compounds such as LiF.

Preferably, the electron injecting layer does not comprise elemental metal with a work function of 3.5eV or less. Most preferably, the electron injecting layer consists essentially of the alkaline earth metal oxide.

Preferably, the alkaline earth metal is barium. It has been found that barium oxide provides particularly good device performance when used with a phosphorescent electroluminescent material.

Preferably, the organic phosphorescent material is disposed in an organic semi-conductive host material. Preferably, the organic semi-conductive host material is capable of emitting blue light. Advantageously, the organic semi-conductive material comprises 1 to 7% amine by molar ratio, more preferably 2 to 6%, more preferably still 2 to 5%. Semi-conductive organic materials which have a low amine content are useful as host materials for phosphorescent emitters. Such materials are able to transfer charge efficiently onto the phosphorescent emitters. It has been found that alkaline earth metal oxides (particularly barium oxide) are excellent electron injecting materials for such host materials.

Preferably, the organic light-emissive layer is in direct contact with the electron injecting material.

The phosphorescent material may be a blue, green, or red emitter as the present invention provides an arrangement in which electrons are efficiently injected into a host material having a very shallow LUMO which can transfer charge efficiently onto a range of phosphorescent emitters. Phosphorescent materials are typically metal complexes, in particular transition metal complexes, e.g. an iridium complex.

In a preferred embodiment the electron-injecting layer has a thickness in the range of from 3nm to 20nm. Advantageously, the electron-injecting layer is transparent and preferably has a transparency in the device of at least 95 %.

In order to provide an ohmic contact for injection of electrons into the device, the cathode preferably comprises a conductive structure disposed on the alkaline earth metal oxide layer. This conductive structure may comprise one or more layers of conducting materials.

In one arrangement, the cathode comprises a conductive metal layer disposed on the alkaline earth metal oxide layer on a side opposite to the organic semi-conductive material, the alkaline earth metal oxide layer being transparent and the conductive metal layer being highly reflective. The conductive metal layer may have a thickness greater than 50nm. The conductive metal layer may have a reflectivity in the device of at least 70 % (as measured by a reflectometer). The conductive metal layer may comprise at least one of Al and Ag.

The aforementioned arrangement has been found to result in highly efficient device performance when compared to prior art devices. One reason for this is the improved electron injection previously discussed. However, another major contributing factor is the greatly improved reflectivity of the bi-layer arrangement comprising an alkaline earth metal oxide and a reflective layer thereon. This result was surprising as, theoretically, a bi-layer of, for example, barium and aluminium should have the same reflectivity as a bi-layer of, for example, barium oxide and aluminium for very thin layers of barium and barium oxide. This is because, the absorption and/or reflection from very thin layers of barium and barium oxide is negligible and thus the reflectivity of aluminium should dominate in the bi-layers. In practice however, it has been found that the reflectivity of the barium oxide/aluminium bi-layer is much higher than the barium/aluminium bi-layer (approximately 20% increase in reflectivity has been measured). The increase in reflectivity results in a highly efficient bottom-emitting device.

In another arrangement, the high transparency of the electron injecting layer makes it suitable for use in transparent cathodes. In this case, a transparent conductive structure may be formed over the electron injecting layer. The transparent conductive structure may comprise, for example, a metal layer that is sufficiently thin to be transparent or a transparent conducting oxide such as indium tin oxide.

In a yet further arrangement, the conductive structure may comprise a bilayer of a first conducting layer having a workfunction below 3.5 eV (for example a layer of Ba or Ca) and a second conducting layer having a workfunction above 3.5 eV (for example a layer of Al).

Organic light emissive devices according to embodiments of the present invention may be utilized as full colour displays in which the organic light emissive layer comprises sub-pixels of red, green and blue electroluminescent materials, and wherein the cathode injects electrons into each sub-pixel. It has been found that the cathode of embodiments of the present invention is useful as a common cathode for red, green and blue electroluminescent materials providing efficient electron injection without adversely reacting with the electroluminescent materials.

By "red electroluminescent material" is meant an organic material that by electroluminescence emits radiation having a wavelength in the range of 600-750 nm, preferably 600-700 nm, more preferably 610-650 nm and most preferably having an emission peak around 650-660 nm.

By "green electroluminescent material" is meant an organic material that by electroluminescence emits radiation having a wavelength in the range of 510-580 nm, preferably 510-570 nm.

By "blue electroluminescent material" is meant an organic material that by electroluminescence emits radiation having a wavelength in the range of 400-500 nm, more preferably 430-500 nm.

In one preferred arrangement, the same organic semi-conductive material is provided in the blue sub-pixel as a fluorescent blue emissive material and in at least one of the red and green sub-pixels as a host material for the phosphorescent red and / or green organic material. Most preferably, the same material is used for the blue emissive material in the blue sub-pixel and as a host for a phosphorescent red emitter in the red emissive sub-pixel. Such an arrangement ensures excellent injection into different types of sub-pixel and obviates the problem of relatively short luminescent half-life of blue phosphorescent materials. Furthermore, materials and processing costs are reduced by using a common material for different functions within a device.

The organic semi-conductive host material is preferably a conjugated polymer. Advantageously, the polymer is a copolymer comprising amine repeat units, preferably triaryamine repeat units. Preferably, the copolymer comprises up to 50 %. amine repeat units, preferably 1-15% amine repeat units, more preferably still 1-10% amine repeat units. The amine provides good hole transport from the anode side of the device, providing sufficient positive charge to balance the increase in electron injection from a cathode according to an embodiment of the present invention.

In order to further increase positive charge in the organic light-emissive layer, a hole injecting material comprising, for example, a conductive organic material is advantageously provided between the anode and the organic light-emissive layer. Examples of organic hole injection materials include PEDT/PSS as disclosed in EP0901176 and EP0947123, or polyaniline as disclosed in US5723873 and US5798170. PEDT/PSS is polystyrene sulphonic acid doped polyethylene dioxythiophene.

More preferably still, in order to provide sufficient positive charge to balance the increase in electron injection from a cathode according to an embodiment of the present invention a layer of hole transport material may be provided between the layer of hole injecting material and the organic light emissive layer. The hole transport material may comprise a semi-conductive organic material such as a conjugated polymer. It has been found that excellent device performance is achieved by utilizing triarylamine containing conjugated polymer hole transporting material. These materials, used in conjunction with a low work function metal oxide or barium compound electron injecting layer and a phosphorescent organic material provide excellent charge injection and charge balance in a device resulting in improved device performance.

Particularly preferred triarylamine repeat units are selected from optionally substituted repeat units of formulae 1-6: 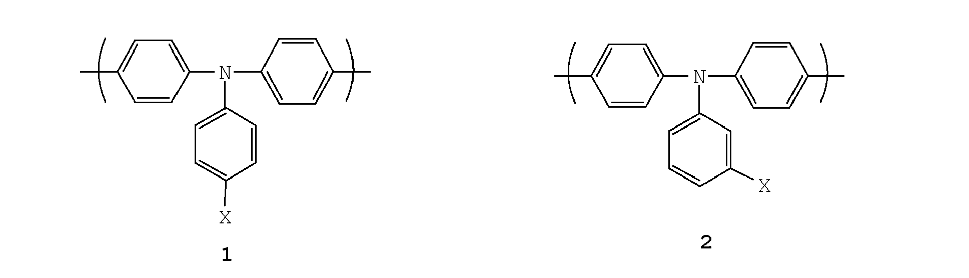 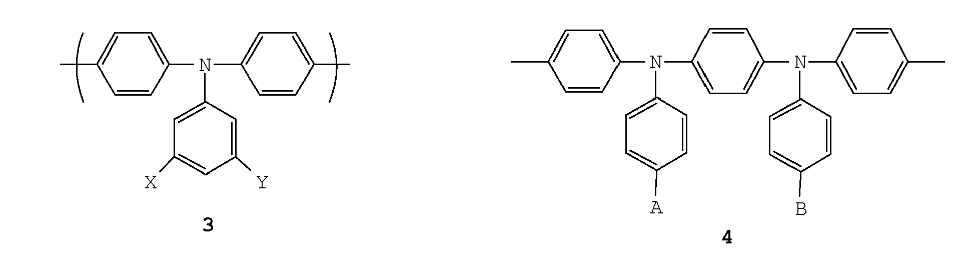 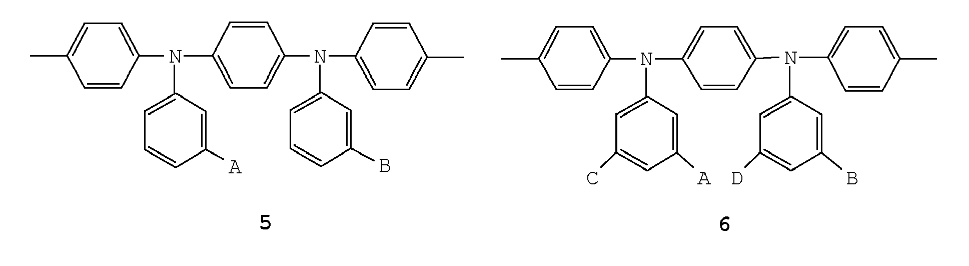 wherein X, Y, A, B, C and D are independently selected from H or a substituent group. More preferably, one or more of X, Y, A, B, C and D is independently selected from the group consisting of optionally substituted, branched or linear alkyl, aryl, perfluoroalkyl, thioalkyl, cyano, alkoxy, heteroaryl, alkylaryl and arylalkyl groups. Most preferably, X, Y, A and B are C₁₋₁₀ alkyl. The aromatic rings in the backbone of the polymer may be linked by a direct bond or a bridging group or bridging atom, in particular a bridging heteroatom such as oxygen.

Also particularly preferred as the triarylamine repeat unit is an optionally substituted repeat unit of formula 6a: 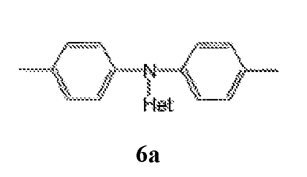 wherein Het represents a heteroaryl group.

Another preferred hole transporting material comprises the repeat unit of general formula (6aa): 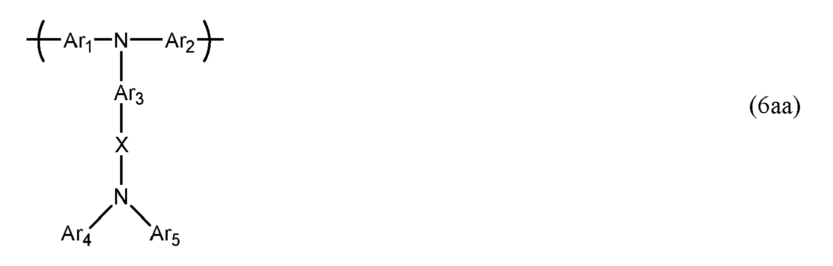 where Ar₁, Ar₂, Ar₃, Ar₄ and Ar₅ each independently represent an aryl or heteroaryl ring or a fused derivative thereof; and X represents an optional spacer group.

Copolymers comprising one or more amine repeat units 1-6, 6a and 6aa preferably further comprise a first repeat unit selected from arylene repeat units, in particular: 1,4-phenylene repeat units as disclosed in J. Appl. Phys. 1996, 79, 934; fluorene repeat units as disclosed in EP 0842208; indenofluorene repeat units as disclosed in, for example, Macromolecules 2000, 33(6), 2016-2020; and spirobifluorene repeat units as disclosed in, for example EP 0707020. Each of these repeat units is optionally substituted. Examples of substituents include solubilising groups such as C₁₋₂₀ alkyl or alkoxy; electron withdrawing groups such as fluorine, nitro or cyano; and substituents for increasing glass transition temperature (Tg) of the polymer.

Particularly preferred copolymers comprise first repeat units of formula 6b: 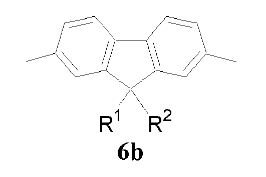 wherein R¹ and R² are independently selected from hydrogen or optionally substituted alkyl, alkoxy, aryl, arylalkyl, heteroaryl and heteroarylalkyl. More preferably, at least one of R¹ and R² comprises an optionally substituted C₄-C₂₀ alkyl or aryl group.

As set out above, copolymers comprising the first repeat unit and an amine repeat unit may be used as hole transporting materials for a hole transporting layer, as host materials for a phosphorescent dopant, and / or as fluorescent materials for use in combination with a phosphorescent material of a different colour to the fluorescent material, in particular green or blue fluorescent materials.

Polymers comprising the first repeat unit may be provided in a polymer without an amine repeat unit. Some examples of other co-repeat units are given later.

As previously stated, it has been found that the cathode of embodiments of the present invention is useful as a common cathode for red, green and blue light emitting materials providing an increase in efficiency without adversely reacting with the emissive materials. A particularly preferred arrangement for a full colour display device utilizes a common barium oxide or other metal oxide electron injecting material on one side of the light-emissive layer and a common triarylamine hole transporting material on the other side of the light-emissive layer. Such an arrangement provides good charge injection and good charge balance for red, green and blue light emitting materials thus providing a highly efficient full colour display which has good lifetime and is also simple to manufacture as common materials are utilized for all the different coloured sub-pixels. The full colour display can be further improved and simplified by using a common material for the blue emitter and as a host for the red and/or green emitter as previously discussed.

According to a second aspect of the present invention there is provided an organic light emissive device comprising: an anode; a cathode; and an organic light emissive layer between the anode and the cathode, wherein the cathode comprises an electron-injecting layer comprising a barium compound or a metal oxide; the organic light emissive layer comprises an organic phosphorescent material; and the electron injecting layer is in direct contact with the organic light emissive layer.

According to a third aspect of the present invention there is provided an organic light emissive device comprising: an anode; a cathode; and an organic light emissive layer between the anode and the cathode, comprising red, green and blue organic electroluminescent materials, wherein the cathode comprises an electron-injecting layer comprising a barium compound or a metal oxide; and at least one of the organic electroluminescent materials emits light by phosphorescence.

Preferred features of the device according to the second aspect of the invention, such as composition of the organic light emissive layer and, where present, organic charge transport or injection layers, are as set out above for the first aspect of the invention.

The displays of the present invention can be manufactured using standard techniques known in the art. In particular, it is advantageous for the organic materials to be deposited using solution processing techniques such as spin coating and ink-jet printing. A particularly preferred technique involves ink-jet printing the light emissive materials in the sub-pixels.

The cathodes of the present invention are useful for pulse driven displays.

The present invention will now be described in further detail, by way of example only, with reference to the accompanying drawings in which:

### Brief Description of the Drawings

FIGURE 1 shows in diagrammatic form a typical cross-sectional structure of an OLED; and
FIGURE 2 shows a cross-sectional structure of an OLED according to an embodiment of the present invention.

### Detailed description of preferred embodiments

Figure 2 shows a cross-sectional structure of an OLED according to an embodiment of the present invention. The OLED is fabricated on a glass substrate 10 coated with a transparent anode 12 comprising an indium-tin-oxide (ITO) layer. The ITO coated substrate is covered with a hole injecting layer 14 of PEDOT-PSS. A hole transport layer 16 comprising a 1:1 regular, alternating copolymer of a fluorene repeat unit and a triarylamine repeat unit is deposited thereon over which is disposed a thin film of an electroluminescent organic material 18 comprising a host material and a phosphorescent organic material. A bi-layer cathode comprising an electron injecting layer 20 of an alkaline earth metal oxide and a reflective layer 22 such as aluminium or silver is disposed over the electroluminescent organic material 18.

The device is preferably encapsulated with an encapsulant (not shown) to prevent ingress of moisture and oxygen. Suitable encapsulants include a sheet of glass, films having suitable barrier properties such as alternating stacks of polymer and dielectric as disclosed in, for example, WO 01/81649 or an airtight container as disclosed in, for example, WO 01/19142. A getter material for absorption of any atmospheric moisture and / or oxygen that may permeate through the substrate or encapsulant may be disposed between the substrate and the encapsulant.

A polymer comprising the first repeat unit (6b) may provide one or more of the functions of hole transport, electron transport and emission depending on which layer of the device it is used in and the nature of co-repeat units.

In particular:
- a homopolymer of the first repeat unit, such as a homopolymer of 9,9-dialkylfluoren-2,7-diyl, may be utilised to provide electron transport.
- a copolymer comprising a first repeat unit and a triarylamine repeat unit, in particular a repeat unit selected from formulae 1-6aa, may be utilised to provide hole transport and / or emission.
- a copolymer comprising a first repeat unit and heteroarylene repeat unit may be utilised for charge transport or emission. Preferred heteroarylene repeat units are selected from formulae 7-21: 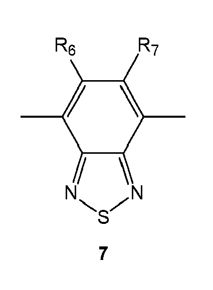 wherein R₆ and R₇ are the same or different and are each independently hydrogen or a substituent group, preferably alkyl, aryl, perfluoroalkyl, thioalkyl, cyano, alkoxy, heteroaryl, alkylaryl or arylalkyl. For ease of manufacture, R₆ and R₇ are preferably the same. More preferably, they are the same and are each a phenyl group.

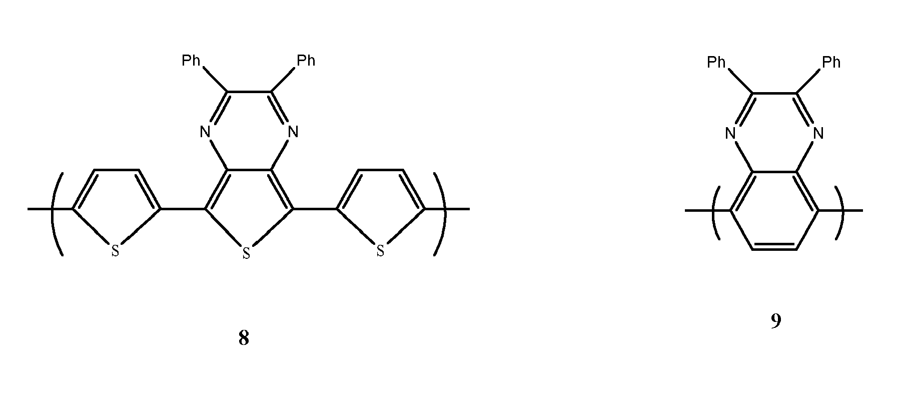

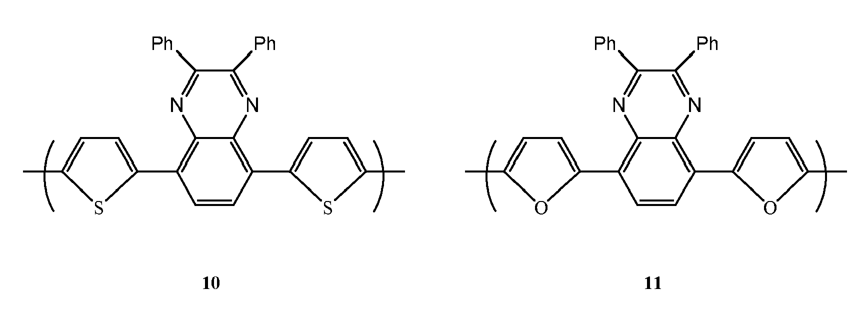

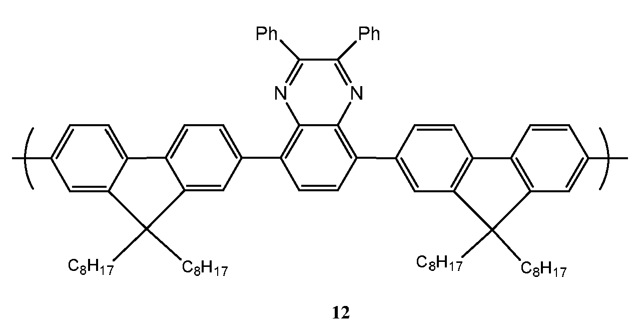

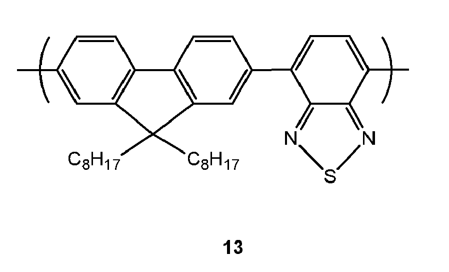

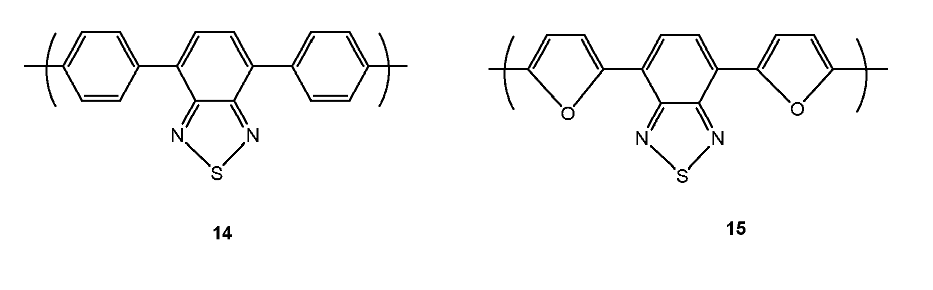

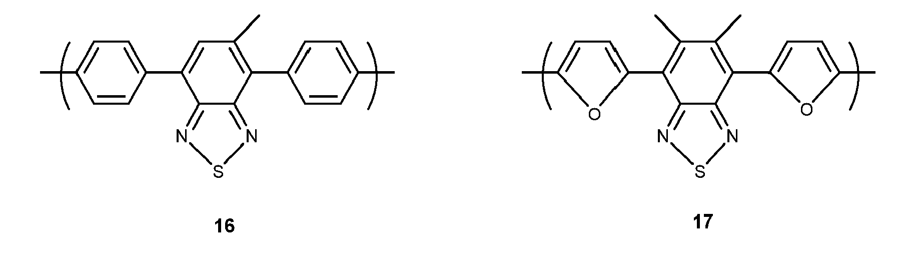

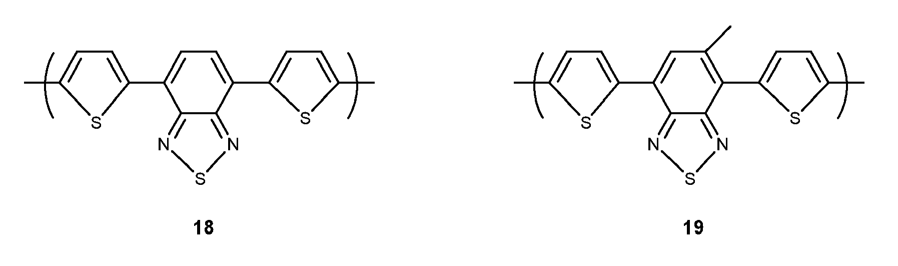

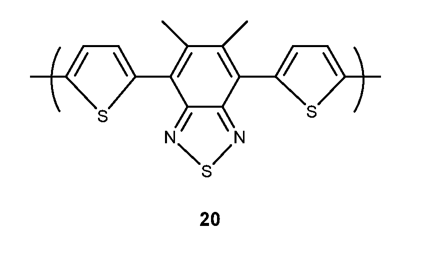

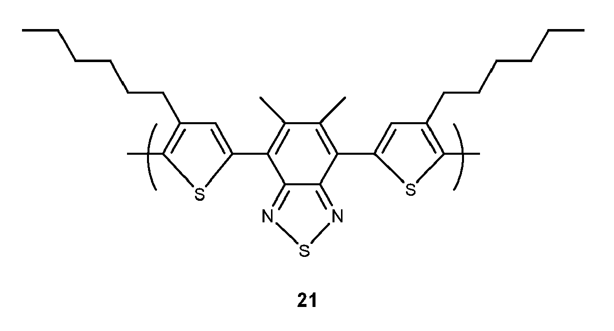

Electroluminescent copolymers may comprise an electroluminescent region and at least one of a hole transporting region and an electron transporting region as disclosed in, for example, WO 00/55927 and US 6353083. If only one of a hole transporting region and electron transporting region is provided then the electroluminescent region may also provide the other of hole transport and electron transport functionality.

The different regions within such a polymer may be provided along the polymer backbone, as per US 6353083, or as groups pendant from the polymer backbone as per WO 01/62869.

Preferred methods for preparation of these polymers are Suzuki polymerisation as described in, for example, WO 00/53656 and Yamamoto polymerisation as described in, for example, T. Yamamoto, "Electrically Conducting And Thermally Stable π - Conjugated Poly(arylene)s Prepared by Organometallic Processes", Progress in Polymer Science 1993, 17, 1153-1205. These polymerisation techniques both operate via a "metal insertion" wherein the metal atom of a metal complex catalyst is inserted between an aryl group and a leaving group of a monomer. In the case of Yamamoto polymerisation, a nickel complex catalyst is used; in the case of Suzuki polymerisation, a palladium complex catalyst is used.

For example, in the synthesis of a linear polymer by Yamamoto polymerisation, a monomer having two reactive halogen groups is used. Similarly, according to the method of Suzuki polymerisation, at least one reactive group is a boron derivative group such as a boronic acid or boronic ester and the other reactive group is a halogen. Preferred halogens are chlorine, bromine and iodine, most preferably bromine.

It will therefore be appreciated that repeat units and end groups comprising aryl groups as illustrated throughout this application may be derived from a monomer carrying a suitable leaving group.

Suzuki polymerisation may be used to prepare regioregular, block and random copolymers. In particular, homopolymers or random copolymers may be prepared when one reactive group is a halogen and the other reactive group is a boronic acid group or derivative thereof, for example a boronic ester. Alternatively, block or regioregular, in particular AB, copolymers may be prepared when both reactive groups of a first monomer are boronic acid groups or derivatives thereof and both reactive groups of a second monomer are halogen.

As alternatives to halides, other leaving groups capable of participating in metal insertion include groups include tosylate, mesylate and triflate.

A single polymer or a plurality of polymers may be deposited from solution to form a layer. Suitable solvents for polyarylenes, in particular polyfluorenes, include mono- or poly-alkylbenzenes such as toluene and xylene. Particularly preferred solution deposition techniques are spin-coating and inkjet printing.

Spin-coating is particularly suitable for devices wherein patterning of the electroluminescent material is unnecessary ― for example for lighting applications or simple monochrome segmented displays.

Inkjet printing is particularly suitable for high information content displays, in particular full colour displays. Inkjet printing of OLEDs is described in, for example, EP 0880303.

If multiple layers of the device are formed by solution processing then the skilled person will be aware of techniques to prevent intermixing of adjacent layers, for example by crosslinking of one layer before deposition of a subsequent layer or selection of materials for adjacent layers such that the material from which the first of these layers is formed is not soluble in the solvent used to deposit the second layer.

Certain preferred polymeric host materials have been described above, however numerous other suitable host materials are described in the prior art including "small molecule" hosts such as 4,4'-bis(carbazol-9-yl)biphenyl), known as CBP, and (4,4',4"-tris(carbazol-9-yl)triphenylamine), known as TCTA, disclosed in Ikai et al. (Appl. Phys. Lett., 79 no. 2, 2001, 156); and triarylamines such as tris-4-(N-3-methylphenyl-N-phenyl)phenylamine, known as MTDATA. Other polymeric hosts include homopolymers such as poly(vinyl carbazole) disclosed in, for example, Appl. Phys. Lett. 2000, 77(15), 2280; polyfluorenes in Synth. Met. 2001, 116, 379, Phys. Rev. B 2001, 63, 235206 and Appl. Phys. Lett. 2003, 82(7), 1006; poly[4-(N-4-vinylbenzyloxyethyl, N-methylamino)-N-(2,5-di-tert-butylphenylnapthalimide] in Adv. Mater. 1999, 11(4), 285; and poly(para-phenylenes) in J. Mater. Chem. 2003, 13, 50-55.

The organic phosphorescent material is preferably a metal complex. The metal complex may comprise an optionally substituted complex of formula (22):

ML¹_{q}L²ᵣL³ₛ (22)

wherein M is a metal; each of L¹, L² and L³ is a coordinating group; q is an integer; r and s are each independently 0 or an integer; and the sum of (a. q) + (b. r) + (c.s) is equal to the number of coordination sites available on M, wherein a is the number of coordination sites on L¹, b is the number of coordination sites on L² and c is the number of coordination sites on L³.

Heavy elements M induce strong spin-orbit coupling to allow rapid intersystem crossing and emission from triplet states (phosphorescence). Suitable heavy metals M include:
- lanthanide metals such as cerium, samarium, europium, terbium, dysprosium, thulium, erbium and neodymium; and
- d-block metals, in particular those in rows 2 and 3 i.e. elements 39 to 48 and 72 to 80, in particular ruthenium, rhodium, pallaidum, rhenium, osmium, iridium, platinum and gold.

Suitable coordinating groups for the f-block metals include oxygen or nitrogen donor systems such as carboxylic acids, 1,3-diketonates, hydroxy carboxylic acids, Schiff bases including acyl phenols and iminoacyl groups. As is known, luminescent lanthanide metal complexes require sensitizing group(s) which have the triplet excited energy level higher than the first excited state of the metal ion. Emission is from an f-f transition of the metal and so the emission colour is determined by the choice of the metal. The sharp emission is generally narrow, resulting in a pure colour emission useful for display applications.

The d-block metals form organometallic complexes with carbon or nitrogen donors such as porphyrin or bidentate ligands of formula (VI): 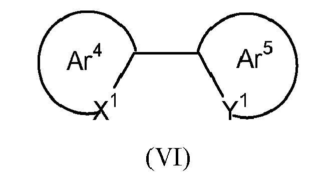 wherein Ar⁴ and Ar⁵ may be the same or different and are independently selected from optionally substituted aryl or heteroaryl; X¹ and Y¹ may be the same or different and are independently selected from carbon or nitrogen; and Ar⁴ and Ar⁵ may be fused together. Ligands wherein X¹ is carbon and Y¹ is nitrogen are particularly preferred.

Examples of bidentate ligands are illustrated below:

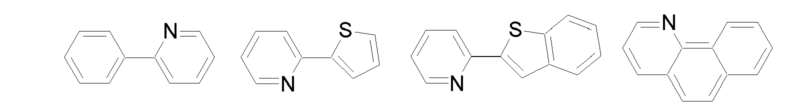

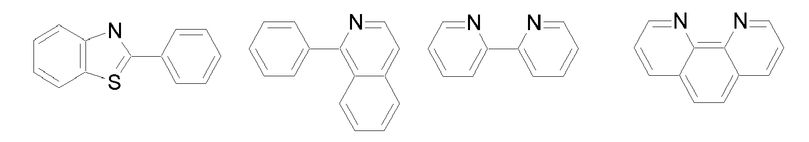

Each of Ar⁴ and Ar⁵ may carry one or more substituents. Particularly preferred substituents include fluorine or trifluoromethyl which may be used to blue-shift the emission of the complex as disclosed in WO 02/45466, WO 02/44189, US 2002-117662 and US 2002-182441; alkyl or alkoxy groups as disclosed in JP 2002-324679; carbazole which may be used to assist hole transport to the complex when used as an emissive material as disclosed in WO 02/81448; bromine, chlorine or iodine which can serve to functionalise the ligand for attachment of further groups as disclosed in WO 02/68435 and EP 1245659; and dendrons which may be used to obtain or enhance solution processability of the metal complex as disclosed in WO 02/66552.

Other ligands suitable for use with d-block elements include diketonates, in particular acetylacetonate (acac); triarylphosphines and pyridine, each of which may be substituted. Main group metal complexes show ligand based, or charge transfer emission. For these complexes, the emission colour is determined by the choice of ligand as well as the metal.

In one preferred arrangement, the metal complex has the formula (A) or (B): 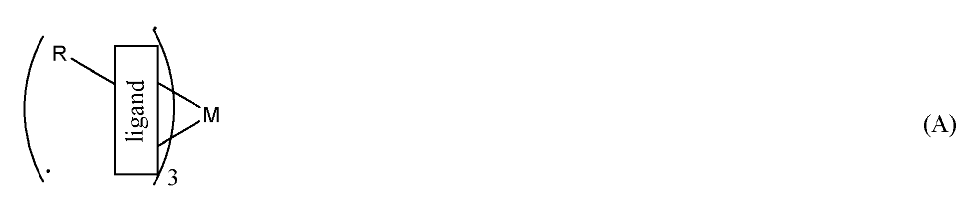 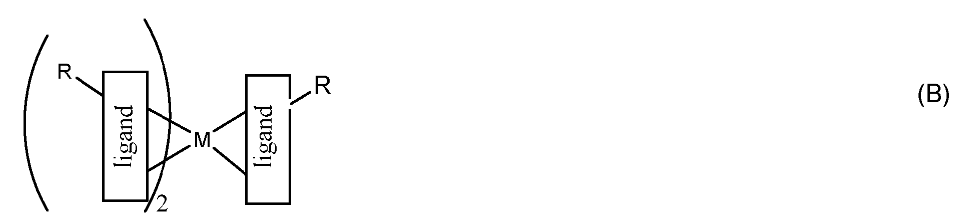 where R represents H or a substituent group, for example a dendron comprising a surface group. Preferred surface groups are solubilising groups, in particular alkyl or alkoxy groups. The ligands can be the same or different. Similarly, the R groups can be the same or different.

The phosphorescent material may comprise a dendrimer such as those shown in formulae (C) and (D): 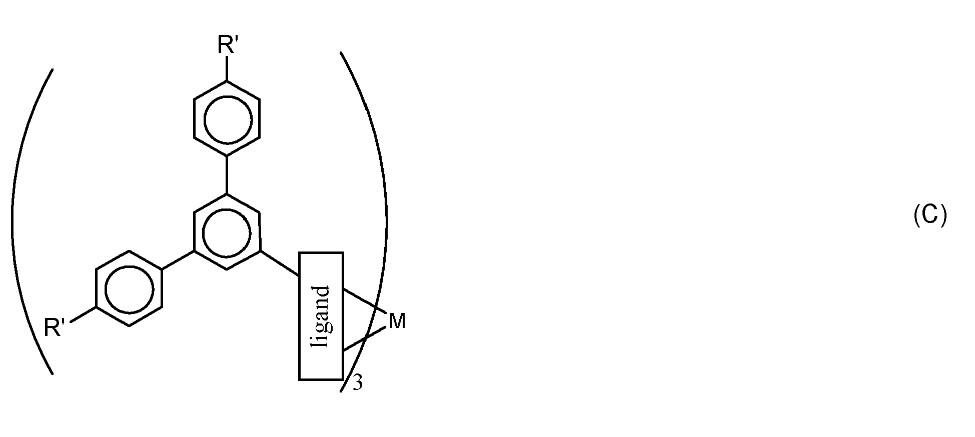 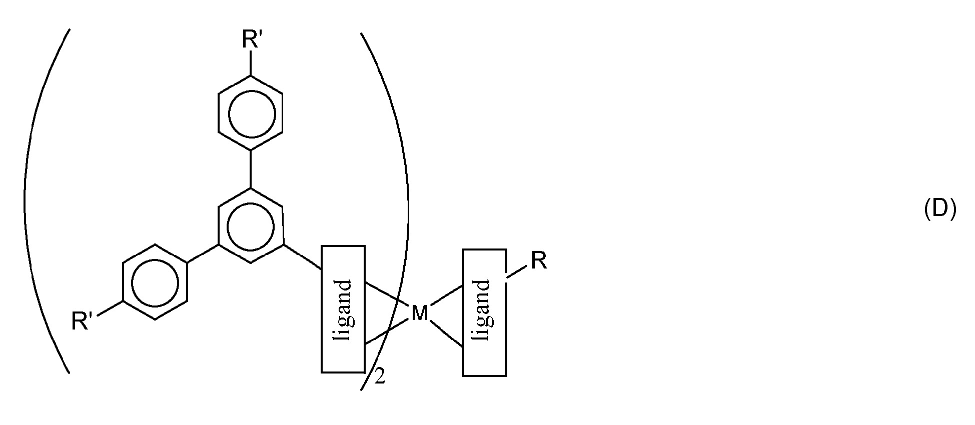 where R represents H or substituent group (which may be a dendron that is different from the dendron attached to the other two ligands), and R' represents H or a surface group. Preferred surface groups are solubilising groups, in particular alkyl or alkoxy groups. The ligands can be the same or different. Similarly, the R groups can be the same or different.

The host material and metal complex may be combined in the form of a physical blend. Alternatively, the metal complex may be chemically bound to the host material. In the case of a polymeric host, the metal complex may be chemically bound as a substituent attached to the polymer backbone, incorporated as a repeat unit in the polymer backbone or provided as an end-group of the polymer as disclosed in, for example, EP 1245659, WO 02/31896, WO 03/18653 and WO 03/22908.

As set out above, the host material used with the organic phosphorescent material may also be used as a fluorescent material in a multicolour display. As an alternative to this, the host material may also be used as the host material for a fluorescent dopant, and in this regard a wide range of fluorescent low molecular weight metal complexes are known and have been demonstrated in organic light emitting devices [see, e. g., Macromol. Sym. 125 (1997) 1-48, US-A 5,150,006, US-A 6,083,634 and US-A 5,432,014], in particular tris-(8-hydroxyquinoline)aluminium. Suitable ligands for di or trivalent metals include: oxinoids, e. g. with oxygen-nitrogen or oxygen-oxygen donating atoms, generally a ring nitrogen atom with a substituent oxygen atom, or a substituent nitrogen atom or oxygen atom with a substituent oxygen atom such as 8-hydroxyquinolate and hydroxyquinoxalinol-10-hydroxybenzo (h) quinolinato (II), benzazoles (III), schiff bases, azoindoles, chromone derivatives, 3-hydroxyflavone, and carboxylic acids such as salicylato amino carboxylates and ester carboxylates. Optional substituents include halogen, alkyl, alkoxy, haloalkyl, cyano, amino, amido, sulfonyl, carbonyl, aryl or heteroaryl on the (hetero) aromatic rings which may modify the emission colour.

### General procedure

The general procedure follows the steps outlined below:
1) Depositing PEDT/PSS, available from Bayer® as Baytron P® onto indium tin oxide supported on a glass substrate (available from Applied Films, Colorado, USA) by spin coating.
2) Depositing a layer of hole transporting polymer by spin coating from xylene solution having a concentration of 2 % w/v.
3) Heating the layer of hole transport material in an inert (nitrogen) environment.
4) Optionally spin-rinsing the substrate in xylene to remove any remaining soluble hole transport material.
5) Depositing an organic light-emissive material comprising a host material and an organic phosphorescent material by spin-coating from xylene solution.
6) Depositing a BaO/Al cathode over the organic light-emissive material and encapsulating the device using an airtight metal enclosure available from Saes Getters SpA.

### Full colour display

A full colour display can be formed according to the process described in EP 0880303 by forming wells for red, green and blue subpixels using standard lithographical techniques; inkjet printing PEDT/PSS into each subpixel well; inkjet printing hole transport material; and inkjet printing red, green and blue electroluminescent materials into wells for red, green and blue subpixels respectively.

### Aspects:

1. An organic light emissive device comprising:
   an anode;
   a cathode; and
   an organic light emissive layer between the anode and the cathode, wherein the cathode comprises an electron-injecting layer comprising an oxide of an alkaline earth metal and wherein the organic light emissive layer comprises an organic phosphorescent material.
2. An organic light emissive device according to aspect 1, wherein the alkaline earth metal is barium.
3. An organic light emissive device according to any preceding aspect, wherein the electron-injecting layer has a thickness in the range of from 3nm to 20nm.
4. An organic light emissive device according to any preceding aspect, wherein the electron-injecting layer has a transparency in the device of at least 95 %.
5. An organic light emissive device according to any preceding aspect, wherein the cathode further comprises a conductive structure disposed on the electron-injecting layer on a side opposite to the organic light emissive layer.
6. An organic light emissive device according to aspect 5, wherein the conductive structure comprises one or more layers of conductive material.
7. An organic light emissive device according to aspect 5 or 6, wherein the conductive structure is reflective.
8. An organic light emissive device according to aspect 7, wherein the conductive structure has a reflectivity of at least 70%.
9. An organic light emissive device according to aspect 7 or 8, wherein the conductive structure comprises a metal layer.
10. An organic light emissive device according to aspect 9, wherein the metal layer has a thickness of at least 50nm.
11. An organic light emissive device according to aspect 9 or 10, wherein the conductive metal layer comprises at least one of Al and Ag.
12. An organic light emissive device according to aspect 11, wherein the conductive metal layer comprises Al.
13. An organic light emissive device according to aspect 5 or 6, wherein the conductive structure is transparent.
14. An organic light emissive device according to aspect 13, wherein the conductive structure has a transparency of at least 95%.
15. An organic light emissive device according to aspect 13 or 14, wherein the conductive structure comprises a thin transparent metal layer or a layer of a transparent conducting oxide.
16. An organic light emissive device according to aspect 6, wherein the conductive structure comprises a bilayer of a first conducting layer disposed on the electron-injecting layer and having a workfunction below 3.5 eV and a second conducting layer disposed on the first conducting layer and having a workfunction above 3.5 eV.
17. An organic light emissive device according to aspect 16, wherein the first conducting layer is a layer of Ba or Ca.
18. An organic light emissive device according to aspect 16 or 17, wherein the second conducting layer is a layer of Al.
19. An organic light emissive device according to any preceding aspect, wherein the organic light emissive layer is in direct contact with the electron-injecting layer.
20. An organic light emissive device according to any preceding aspect, wherein the organic light emissive layer comprises an organic semi-conductive host material in which the organic phosphorescent material is disposed.
21. An organic light emissive device according to aspect 20, wherein the organic semi-conductive host material is capable of emitting blue light.
22. An organic light emissive device according to aspect 20 or 21, wherein the organic semi-conductive host material has a LUMO between 0 and ―2.1eV.
23. An organic light emissive device according to any one of aspects 20 to 22, wherein the organic semi-conductive host material comprises a conjugated polymer.
24. An organic light emissive device according to aspect 23, wherein the polymer is a copolymer comprising up to 50% amine repeat units.
25. An organic light emissive device according to aspect 24, wherein the copolymer comprises 1-15% amine repeat units.
26. An organic light emissive device according to aspect 25, wherein the copolymer comprises 1-10% amine repeat units.
27. An organic light emissive device according to aspect 23 to 26, wherein the polymer comprises fluorene repeat units.
28. An organic light emissive device according to any preceding aspect, wherein the organic phosphorescent material is a red emissive material.
29. An organic light emissive device according to any preceding aspect, wherein the organic phosphorescent material is a metal complex.
30. An organic light emissive device according to aspect 29, wherein the metal complex comprises iridium.
31. An organic light emissive device according to any one of aspects 29 or 30, wherein the metal complex has the formula (A) or (B): 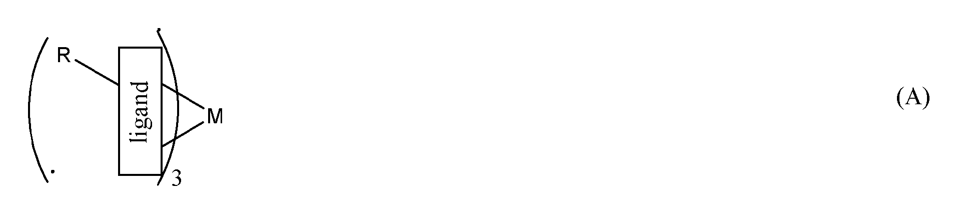 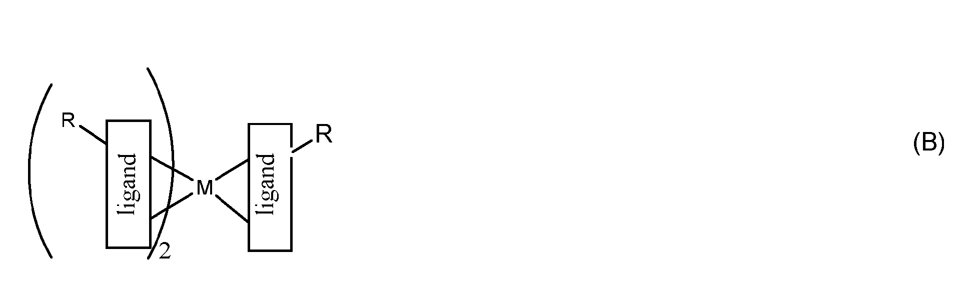 where M represents a metal and R represents H, a substituent group, or a dendron comprising a surface group.
32. An organic light emissive device according to any preceding aspect, wherein the organic phosphorescent material comprises a dendrimer.
33. A organic light emissive device according to aspect 32, wherein the dendrimer has formula (C) or (D): 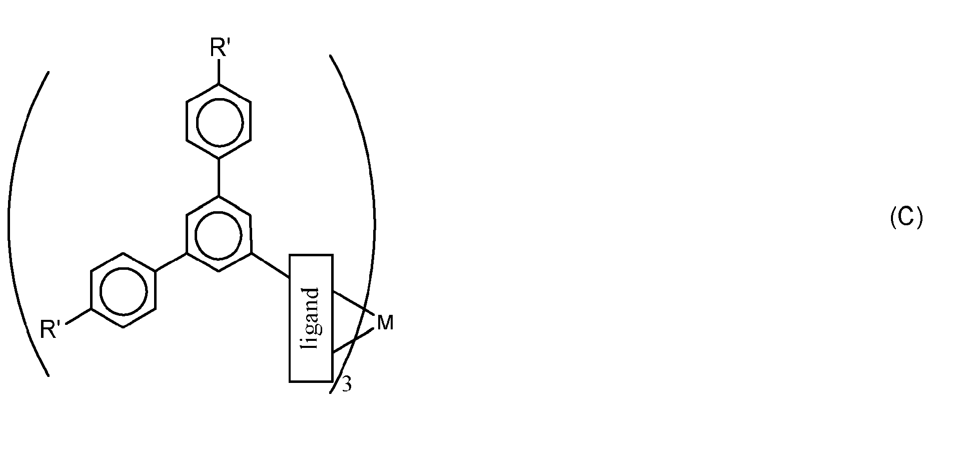 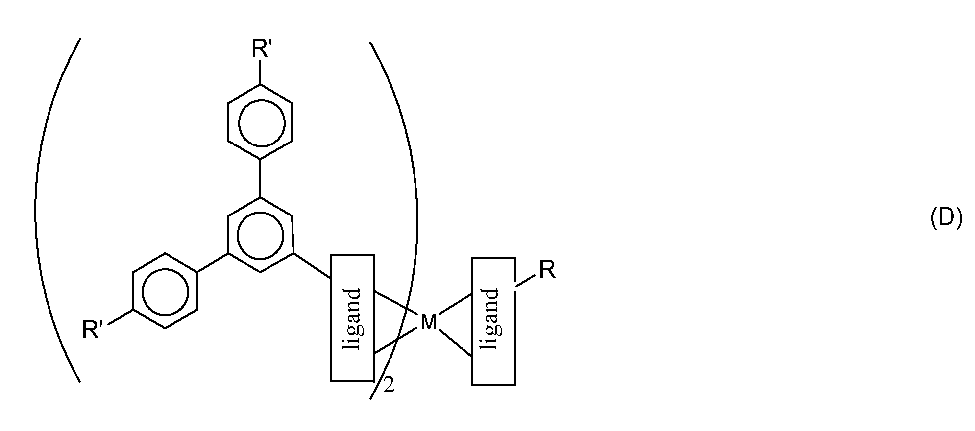 where M represents a metal, R represents H, a substituent group, or a dendron comprising a surface group, and R' represents H or a surface group.
34. A organic light emissive device according to aspect 33, wherein the surface groups are solubilising groups.
35. A organic light emissive device according to aspect 34, wherein the solubilising groups comprise alkyl or alkoxy groups.
36. An organic light emissive device according to any preceding aspect, which is a bottom-emitting device.
37. An organic light emissive device according to any preceding aspect, wherein the device further comprises a substrate on which the anode is disposed, the substrate comprising an active matrix.
38. An organic light emissive device according to any preceding aspect, wherein the organic light emissive layer comprises subpixels of red, green and blue light emitting materials, and wherein the cathode injects electrons into each subpixel.
39. An organic light emissive device according to aspect 38, wherein the same material is provided in the blue sub-pixel as a blue emissive material and in at least one of the red and green sub-pixels as a host material.
40. An organic light emissive device according to any preceding aspect, wherein a layer of hole injecting material is provided between the anode and the organic light emissive layer.
41. An organic light emissive device according to aspect 40, wherein the hole injecting material comprises a conductive organic material.
42. An organic light emissive device according to aspect 41, wherein the conductive organic material comprises a conductive polymer.
43. An organic light emissive device according to any one of aspects 40 to 42, wherein a layer of hole transport material is provided between the layer of hole injecting material and the organic light emissive layer.
44. An organic light emissive device according to aspect 43, wherein the hole transport material comprises a semi-conductive organic material.
45. An organic light emissive device according to aspect 44, wherein the semi-conductive organic material comprises a conjugated polymer.
46. An organic light emissive device according to any preceding aspect, wherein the electron injecting layer does not comprise elemental metal with a work function of 3.5eV or less.
47. An organic light emissive device according to any preceding aspect, wherein the electron injecting layer consists essentially of the alkaline earth metal oxide.
48. An organic light emissive device comprising: an anode; a cathode; and an organic light emissive layer between the anode and the cathode, wherein the cathode comprises an electron-injecting layer comprising a barium compound or a metal oxide; the organic light emissive layer comprises an organic phosphorescent material; and the electron injecting layer is in direct contact with the organic light emissive layer.
49. An organic light emissive device comprising: an anode; a cathode; and an organic light emissive layer between the anode and the cathode, comprising red, green and blue organic electroluminescent materials, wherein the cathode comprises an electron-injecting layer comprising a barium compound or a metal oxide; and at least one of the organic electroluminescent materials emits light by phosphorescence.

## Claims

1. An organic light emissive device comprising: an anode; a cathode; and an organic light emissive layer between the anode and the cathode, wherein the cathode comprises an electron-injecting layer comprising a barium compound or a metal oxide; the organic light emissive layer comprises an organic phosphorescent material; and the electron injecting layer is in direct contact with the organic light emissive layer.

2. An organic light emissive device according to claim 1 wherein the organic light emissive layer comprises red, green and blue organic electroluminescent materials of which at least one emits light by phosphorescence.

3. An organic light emissive device according to any preceding claim, wherein the electron-injecting layer has a thickness in the range of from 3nm to 20nm.

4. An organic light emissive device according to any preceding claim, wherein the electron-injecting layer has a transparency in the device of at least 95 %.

5. An organic light emissive device according to any preceding claim, wherein the cathode further comprises a conductive structure disposed on the electron-injecting layer on a side opposite to the organic light emissive layer, optionally one or more layers of conductive material.

6. An organic light emissive device according to claim 5, wherein the conductive structure is reflective, and optionally has a reflectivity of at least 70%.

7. An organic light emissive device according to claim 6, wherein the conductive structure comprises a metal layer, optionally a metal layer having a thickness of at least 50nm.

8. An organic light emissive device according to claim 7, wherein the conductive metal layer comprises at least one of Al and Ag.

9. An organic light emissive device according to claim 5, wherein the conductive structure is transparent, optionally having a transparency of at least 95%.

10. An organic light emissive device according to claim 9, wherein the conductive structure comprises a thin transparent metal layer or a layer of a transparent conducting oxide.

11. An organic light emissive device according to claim 5, wherein the conductive structure comprises a bilayer of a first conducting layer disposed on the electron-injecting layer and having a workfunction below 3.5 eV and a second conducting layer disposed on the first conducting layer and having a workfunction above 3.5 eV.

12. An organic light emissive device according to claim 11, wherein the first conducting layer is a layer of Ba or Ca.

13. An organic light emissive device according to claim 11 or 12, wherein the second conducting layer is a layer of Al.

14. An organic light emissive device according to claim 2, wherein the organic light emissive layer comprises subpixels of red, green and blue light emitting materials, and wherein the cathode injects electrons into each subpixel, and wherein the same material is provided in the blue sub-pixel as a blue emissive material and in at least one of the red and green sub-pixels as a host material.

15. An organic light emissive device according to any preceding claim, wherein the electron injecting layer does not comprise elemental metal with a work function of 3.5eV or less.
